# EUROPEAN PATENT APPLICATION

(11) **EP 4 819 805 A1**
(43) Date of publication of application: **07.10.2026**
(21) Application number: 25168135.9
(22) Date of filing: 02.04.2025
(51) Int. Cl.: H10K 10/00

(54) **SIGNAL PROCESSOR**

(71) Applicant: Walla, Peter J., 38106 Braunschweig (DE)
(72) Inventor: Walla, Peter J., 38106 Braunschweig (DE)
(74) Representative: Taruttis, Stefan Georg

(57) **Abstract**

A signal processor comprising an array of nano-units, each having at least two possible electronic states, the array having at least one nano-unit located at an input position and at least one nano-unit located at an output position, wherein in the array nano-units are arranged adjacently at a spacing and/or optionally at relative orientations set up for transfer of excitons from the input position to the output position, an input device arranged to energize the nano-units located at at least one input position of the array of nano-units, a detector set up to detect excitons emanating at the output position of the array and/or the state of excitation of nano-units located at the output position of the array.

## Description

The present invention provides a signal processor suitable as a data processor, a process for producing the signal processor, and a process for processing data using the signal processor. The signal processor has the advantage of allowing very fast processing of a signal from an input position to an output position. The processor may comprise at least one carrier which is devoid of electrical lines and devoid of photon waveguiding lines and devoid of electrically conductive or photon pathways connecting an input position to an output position of the processor, further optionally devoid of electrically conductive or photon pathways connected to an input position to an output position of the processor. The processor may comprise pathways encoding signals by electronic excitations or excitons. Due to the absence of electrically conductive and photon pathways connecting an input position to an output position and optionally the absence of electrically conductive and photon pathways connected to an input position to an output position, the signal processor is faster because no charged electrons are conducted and less sensitive to electric fields and/or to magnetic fields than e.g. a microelectronic processor and smaller and thus also faster than optical processors since no photons are moved within optical waveguides of dimemsion of the light wavelengths.

In embodiments, the signal processor may comprise a carrier which is no semiconductor or no optical waveguide and/or the signal processor between its input position and its output position may be devoid of micro-electronic elements or optical waveguides.

In embodiments, the signal processor between its input position and its output position is devoid of electrical or semiconductor lines and does not rely on conducting electric charges.

Further, the processor does not depend on conducting photons, which typically would require photon guiding materials of dimensions on the order of micrometers, but the signal processor contains molecules or nanoparticles having dimensions significantly smaller than 10 nm or than 1 nm. The signal processor of the invention relies on localisation of excited electronic states at one or more molecules or nanoparticles, and transfer of excited electronic states as excitons, e.g. by radiationless transfer of energy between molecules or nanoparticles. Herein, the excitable molecules or nanoparticles are collectively termed nano-units, which include chemical compounds such as dyes, fluorescent compounds, nanoparticles, quantum dots.

In the signal processor, logic operations are performed by transfer of excitons between nano-units. Depending on the characteristics of a nano-unit, the transfer of excitons can occur in one or more excited electronic states or one or more electronic ground states of a nano-unit, and in the nano-unit receiving one or more excitons, its electronic ground state or electronic excited state present prior to receiving one or more excitons is elevated to a higher excited electronic state. Generally, transfer of excitons from one nano-unit to an adjacent nano-unit can be ultrafast, e.g. faster than 100 ps, than 10 ps, or faster than 1 ps or faster than 100 fs, than 10 fs, or faster than 1 fs. These transfers of excitons in the signal processor represent logic operations, which typically occur in at least two interacting nano-units or in an array of nano-units, e.g. in a network of such nano-units. An array of nano-units can be a linear arrangement, a 2-dimensional or a 3-dimensional arrangement of nano-units, also referred to as a network. Generally, each or at least one nano-unit can be very small, e.g. smaller than 10 nm, than 1 nm, or smaller than 0.1 nm. Each embodiment of an array is each set up to process a signal between the input position and the output position of the array by transfer of excitons between nano-units. As a result of the transfer of excitons being ultrafast, the array of nano-units of the signal processor is designed to process logic operations on an ultrafast timescale. Generally, the transfer of an exciton from one nano-unit to an adjacent nano-unit or within a nano-unit can occur by ultrafast excitation energy transfer (EET) between nano-units or by internal conversion (IC) between different electronic states within a nano-unit. The logic operations can, at least in part, be adjusted by the fact that EET depends on the orientation between different nano-units. For example, nano-units consisting of molecules have transition dipole moments. When the transition dipole moments of two nano-units are parallel, then ultrafast exciton transfer occurs, when they are perpendicular to one another virtually no exciton transfer occurs, and angles between 0° and 90° can be used to gradually adjust the timescale of exciton flow from one nano-unit to another. Advantageously, the signal processor can be set up and can operate without a vacuum being applied, e.g. at normal atmospheric pressure, and at ambient or room temperature, i.e. without temperature-control, especially without cooling. Since in the array of the signal processor no electrons are transferred physically the signal processor can also operate at smaller dimensions than e.g. micro-electronic elements. As the excitons which are transferred by the array of nano-units are not charged electrically, they do not have electric fields that could influence neighbouring units at distances larger than 1 or 10 nm. Thus, the lower limit of the dimension for one nano-unit is the size of a single molecule, nanoparticle, or also a single atom forming a nano-unit. Since no electrons need to be transferred physically the signal processor can also operate with less energy consumption than micro-electronic elements as no charged particles need to be moved around and therefore no electric resistance exists that leads to heat losses. Since the dimensions are small and since no charged particles need to be transferred the processor can also operate much faster than a processor using micro-electronic elements which due to larger size and energy requirements of electrons being exchanged between micro-electronic elements work on time scales of several ps. In the signal processor of the invention, excitons are exchanged between nano-units on a fs-timescale.

The array of nano-units, e.g. in a 2-dimensional array or in a 3-dimensional array, each optionally forming a network, can be set up to perform the function of logic operations such as a full adder or a half adder, or can be set up to perform logic operations of a neuronal network or logic operations of matrix conversion, e.g. matrix multiplication, each on the very fast time scale of exciton transfer.

### Object of the invention

It is an object of the invention to provide an signal processor which is an alternative to micro-electronic devices, and preferably a signal processor which allows faster processing of signals. More preferred, the signal processor shall have an array of units which is set up for processing data and which contains little to no electric sensitivity to electric or magnetic fields and little to no energy losses due to electric resistance or contains little to no photonic lines in order to minimize to minimize the dimensions and processing times of the processor.

### Description of the invention

The invention achieves the objects by the features of the claims and in particular by a signal processor comprising
- an array of at least two nano-units, each having at least two possible electronic states, the array having at least one nano-unit located at an input position and at least one nano-unit located at an output position, wherein in the array nano-units are arranged adjacently at a spacing and/or optionally at relative orientations set up for transfer of excitons from the input position to the output position, wherein preferably the spacing is set up for transfer of excitons on an ultrafast timescale,
- an input device arranged to energize the nano-units located at at least one input position of the array of nano-units,
- wherein preferably the array comprises or consists of excitable nano-units located at positions with a spacing between positions, the spacing and orientation of nano-units allowing for exciton transfer between nano-units located adjacent to one another , e.g. for exciton transfer by non-radiative energy transfer, e.g. by Förster resonance energy transfer (FRET), optionally additionally by radiation,
- a detector set up to detect excitons emanating at the output position of the array and/or the state of excitation of nano-units located at the output position of the array,
- wherein optionally the array is set up for emitting at the output position excitons generated by processing excitons between the input position and the output position,
- and wherein optionally the array is set up for emitting photons at the output position in addition to excitons.

As the transfer of excitons between nano-units in addition to the spacing of nano-units can depend on the relative orientation of the nano-units to one another, the signal processor according to the invention can be set up such that the transfer of excitons between nano-units depends on the relative orientation of the nano-units to one another. Therein, the relative orientation of the nano-units to one another can be pre-determined and fixed, and/or the relative orientation of the nano-units to one another can be manipulated for changing the transfer of excitons. Accordingly, at least one of or all of the nano-units can be selected to have a transition dipole moment, the relative orientation of which to another nano-unit determines the efficacy of exciton transfer, and/or at least one of or all of the nano-units can be selected to have a transition dipole moment for which the transfer of excitons is independent from the relative orientation of the transition dipole moment to another nano-unit.

The at least one nano-unit located at the input position of the array provides an input location to be energized by an input device, and the at least one nano-unit located at the output position provides an output location, the state of excitation of which output location and/or emission of excitons and/or of photons is detected by the detector. The input device can operate by emitting electrons or photons of different times, wavelengths and/or polarisations or other physical inputs that can energize the nanounits at the input.

The array may have more than one input position, each of which for being energized by the input device, and/or the array may have more than one output position, preferably the detector being set up to detect the state of excitation of nano-units located at the output position and/or for detecting excitons emitted at the output position.

The detector can be set up for detecting the excitation state of at least one nano-unit located at an output position of the array, e.g. the detector can be set up for pump-probe spectroscopic measurement, and/or the detector can comprise nanoelectronics and/or photon detectors that detect different times, wavelengths or polarisation of emitted excitons and/or photons.

The nano-units are composed of at least one species of excitable molecules, e.g. dye compounds, fluorescent compounds, nano-particles, quantum dots, or combinations of at least two of these.

Generally, the nano-units in the array have an orientation that allows for transfer of excitons between nano-units located in adjacent locations. For nano-units that have a transition dipole moment, adjacent nano-units can be arranged with their transition dipole moment in parallel to allow signal transfer on ultrafast time scales in logic operations or be arranged with angular offset in order to reduce transfer of excitons, e.g. up to 90° offset to minimize or prevent transfer of excitons and thus signal transfer in logic operations.

Preferably, in the array at least one nano-unit has at least one lower and one higher possible excitation states and can receive excitons resulting in energizing to the lower or to the higher excitation state, wherein at least one, preferably at least two adjacently arranged nano-units are set up to emit the excitons.

The nano-units can be arranged on a carrier and/or arranged directly adjacent to one another, additionally or alternatively chemically linked to one another, e.g. directly or by a linker group. In the array, preferably adjacent nano-units are oriented with their transition dipole moments in parallel, optionally at least two of the nano-units have non-parallel orientations of their transition dipole moments.

The excitation transfer transfers energy, herein also referred to as excitons, between excitable nano-units located adjacent to one another in the array . An advantage of the device is that energy transfer by transfer of excitons occurs very fast, e.g. in the range of a few fs.

The excitable molecules located at a position can be present as a single nano-unit or as a group of at least two nano-units, preferably the same molecules or at least two different molecules, independently for each position of the array. The excitable nano-units , preferably organic molecules or nanoparticles, generally have at least one excitation level, e.g. an electronic ground state or an excited electronic state, at which they accept or absorb excitons to obtain a higher state of excitation, and a level lower than the excitation level at which level they donate or emit excitons, e.g. resulting in that donated or emitted excitons have a lower energy than the accepted or absorbed excitons. Nano-units, also referred to as excitable molecules, can e.g. be nanoparticles, quantum dots or aromatic molecules, e.g. dyes, fluorescent compounds.

Preferably, the nano-units located at a position of the array are in a fixed position and fixed orientation with respect to each other, e.g. fixed to one another and/or fixed to a carrier. Changing the position or orientation is an option to program the array. An array can be fixed, i.e. not able to be re-programmed, or programable, e.g. by self-rearrangement processes or external processes, e.g. effected by photons or electrons. One example for re-programming is inducing conformational changes in the orientation by, for example, photochemsistry with different wavelengths, photon polarisations or photon pulse sequences.

The array preferably is set up such that it comprises nano-units with appropriate orientations which nano-units are located to allow energy transfer from the input position to the output position, e.g. the nano-units are arranged in positions of the array to form at least one path which is without interruptions for at least one period in time, in which path the nano-units in adjacent positions from input position to output position may have successively lower excitation levels, and/or in which path at least one, preferably at least two nano-units are arranged adjacent a nano-unit that has at least two possible excitation states above its electronic ground state, allowing excitons of lower energy to bring the nano-unit having at least two possible excitation states to its second higher excitation state.

The array can optionally be energized by at least one further energizing, e.g. a repetition of energizing by one input device or by an additional input device. Such a further energizing results in refreshing the path of transfer of excitons by the additional excitation to ensure that excitation energy is not entirely lost across the array, e.g. from the input position to the output position.

Generally preferred, the array of excitable molecules is no electronic device, e.g. no array of electronic elements in a semiconductor, because in the device the energy transfer from the input position to the output position occurs by transfer of excitons along the array of excitable molecules, each in a position of the array, wherein the energy transfer is without electric contact, between excitable molecules. In the array, the excitable molecules are e.g. arranged with a spacing in the range of 0.01 to 10 nm, e.g. up to 7 or up to 5 nm. The positions of the array may be arranged with a spacing in the range of 0.01 to 10 nm, e.g. up to 3 nm, up to 7 nm or up to 5 nm in each case.

The positions and orientations in which nano-units are located are provided on or within a carrier, which preferably is a solid carrier, e.g. of ceramic, glass, silicon, synthetic polymer, metal, two-dimensional or three-dimensional carbon lattices, e.g. Fullerenes, metal organic frame works, or a combination of at least two of these. In the array, the excitable nano-units could also be arranged or aggregated with each other at distances and orientations allowing for transfer of excitons, without a carrier or linker between nano-units or the nano-unit can be directly, without a linker between them, covalently linked together, e.g. forming a polymer-like network.

The input position comprises at least one, preferably at least two, positions of the array, wherein the positions of the array forming the input position may be located at an edge and/or within the array, and wherein these positions may be adjacent or spaced from one another.

The output position comprises at least one, preferably at least two, positions of the array, which positions of the array may be adjacent or spaced from one another, and with a spacing from the input position. The output position may comprise positions of the array located at an edge and/or within the array.

The input device is set up to energize the nano-units of the input position. The input device may e.g. comprise at least one irradiation source, e.g. guided by optical fibres to the input position, and/or a voltage source, guided by electrical lines to the input position.

The input device can be set up to energize the input position in temporal sequences in order to encode input and/or output information, e.g. on ultrafast timescales. The input information can e.g. be an input string, and the radiation emitted by the input device can be modulated in dependence on the input string in order to encode the input string. As an alternative or in addition, the input device can energize two or more spatially separated input positions. The input device can optionally be set up to encode input information by energizing the input position in at least two different wavelengths (λ), and/or at least two different polarisations of energizing light irradiated onto an input position, or be set up for a combination of these. Accordingly, the input device can be set up to emit irradiation in a pulse sequence, to emit irradiation of different wavelengths, and/or of different polarisation, each of which is modulated in dependence on an input string.

The array is set up to transfer energy from the input position to the output position while reducing the overall energy level of the excitons and modifying the position of excitons within the array. In accordance with reduction of energy by absorption of excitons and emission of excitons of a lower energy by excitable nano-units, the direction of energy transfer is dictated by the arrangement and excited state energy characteristics of the nano-units and by their positions and orientations within the array.

In addition to nano-units that absorb/accept and emit/donate excitons, the array can contain nanoparticles and/or chemical compounds which cannot absorb/accept excitons and/or which can absorb/accept but not emit/donate excitons, and/or which can adopt at least two electronic states depending on energy transfer or occupation by electrons, resulting in switchable nano-units that have accepting/absorption characteristics and/or donating/emission characteristics for excitons depending on energy or electron transfer. In general, it is desired that the array is designed such that the reduction of energy of the involved excited states in the direction of exciton transfer, resp. excitonic flow, is kept to a minimum, e.g. in order to save energy loss and to reduce generation of heat during the transfer of excitons across the array.

For splitting energy that energizes the input position of the array, the input device may be set up for splitting the energy into a sequence of energy pulses, e.g. by irradiating with a fs-pulse laser a mirror lattice to split up the initial laser beam into partial beams, e.g. into 2 to 12 partial beams, each of which is reflected by a mirror arranged to generate a time delay between partial beams, e.g. of 50 fs, wherein the mirrors are set up to direct the partial beams to the input position.

The detector, e.g. set up for pump-probe spectroscopy, may be optically coupled to the output position by a near-field optical fibre.

The invention is also described in general and with reference to the figures, which schematically show in
- Fig. 1 excitation states of nano-units with two input units A,B and one output unit O when transferring excitons for a half or full adder,
- Fig. 2 excitation states of nano-units comprising a full adder when transferring the Carry signal Cₒᵤₜ excitons to a transfer nanounit T,
- Fig. 3 excitation states of nano-units comprising a full adder when transferring the Carry signal Cₒᵤₜ excitons to another full adder unit ,
- Fig. 4 transfer of excitons between nano-units for a neuronal network logic with input, hidden and output layers,
- Fig. 5 transfer of excitons from several nano-units to one receiving nano-unit,
- Fig. 6 energizing input positions of an array by differing wavelengths,
- Fig. 7 energizing input positions of an array by energy pulses,
- Fig. 8 an embodiment of a detector arrangement,
- Fig. 9 exitons resulting in photons of different wavelengths at the output position,

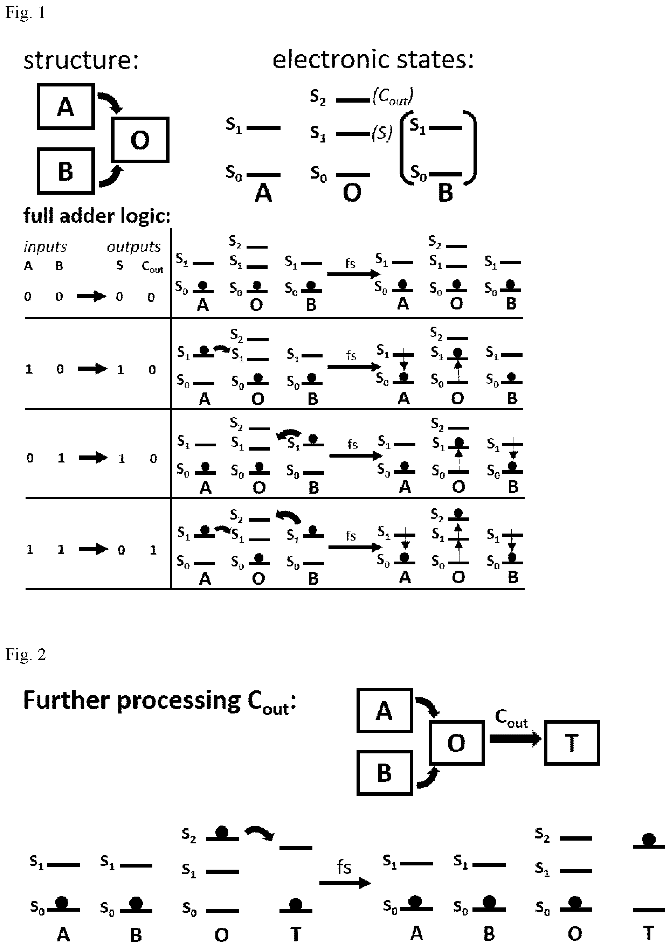

- Fig. 1 0 exitons arriving in pulses at the output position,

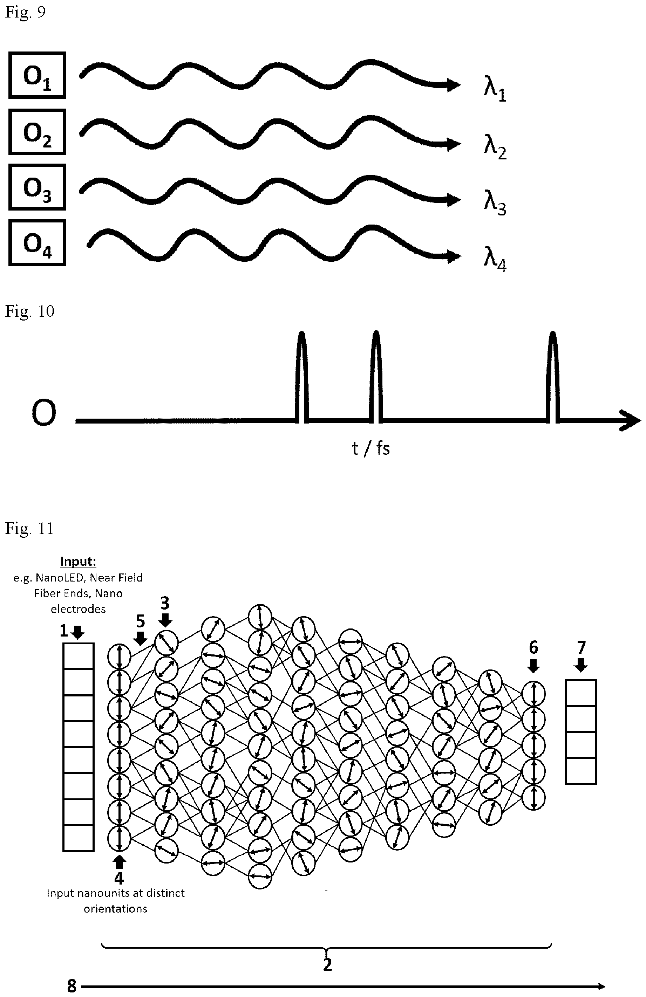

- Fig. 11 a signal processor of the invention, and in

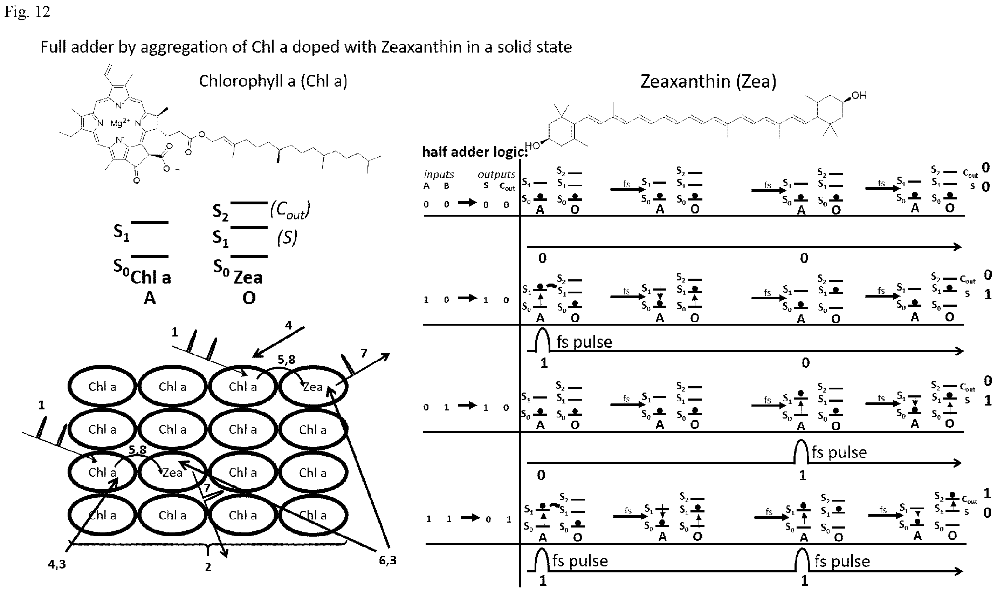

- Fig. 12 a simple half adder consisting of chlorophyll a (Chl a) and zeaxanthin (Zea ) molecules as nano-units, and

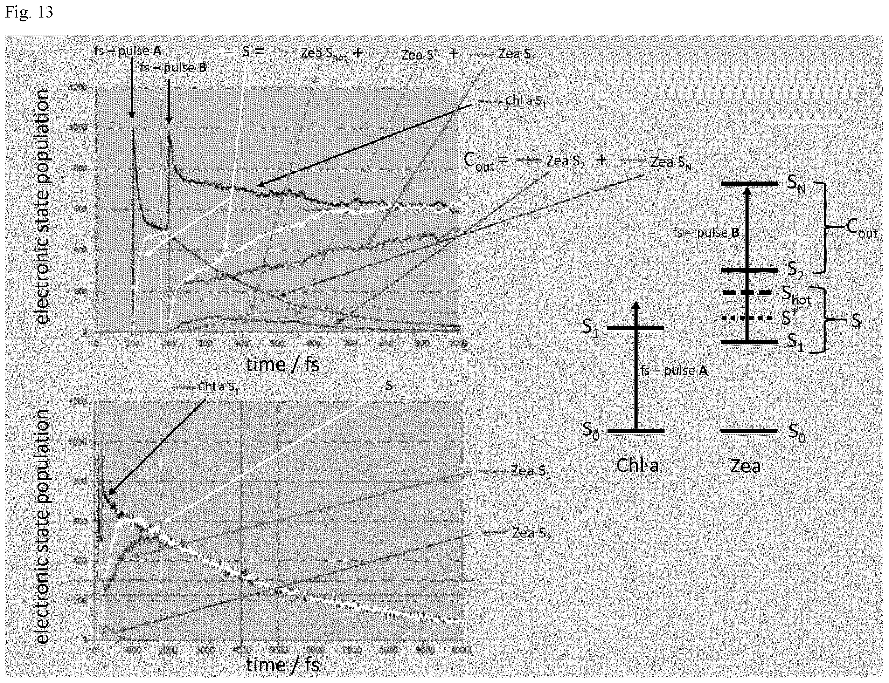

- Fig. 13 time dependence of various excited electronic states of the nano-units of the example shown in Fig. 12.

The signal processor allows for signal processing, e.g. logical operations, based on processes in which two or more excitons lead to the formation of one exciton of higher energy, depicted in Fig. 1. For example, for a nano-unit O that has at least three possible excitation states, one electronic ground state S₀ and two excitation states S₁ and S₂, exciton transfer from one neighboured nano-unit A can first populate the nanounit O from the electronic ground state to the first exited state, S₀ → S₁, on an ultrafast timescale. By this, one first exciton has been transferred from nano-unit A to nano-unit O, now being in the first excited state S₁. Now, the same neighboring nano-unit A or another neighbouring nano-unit B can transfer either sequentially or simultaneously another exciton on the fs-timescale to the nano-unit O promoting nano-unit O into the second excited state S₂ which has a higher energy than each of the two excitons used to sequentially or simultaneously excite nano-unit O into S₂. In summary, two excitons from the nano-units A and/or B have been converted into one exciton of higher energy located on nano-unit O in electronic state S₂. This example does already comprise a logic half-adder operating at fs-timescale and at dimensions of about 1 nm when the original two excitons at the neighboring nano-units A and/or B constitute the two inputs A and B of a half adder and the excited state S₁ of the nano-unit O constitutes the sum output S of a half adder. The second excited state S₂ of the nano-unit O then compromises the Carry (C_{Out}) of a half adder.

The outputs of this unit could simply be read out by, for example, transient absorption or fluorescence either of the electronic state S₁ or electronic state S₂ of the nanounit O. However, in a network, this output signal can also be further processed by further exciton transfers, e.g. with additional nano-units; T, arranged next to the nanounit O, on the fs time scale. For example, the Carry (C_{Out}) signal from the first logic excitonic circuit A/B/O can now be transferred to the neighbouring transfer nano-unit, T, at suitable distance, orientation with suitable electronic state energies (Fig. 2). According to Förster Theory and as demonstrated in energy in photonsynthetic light-harvesting complexes, for example, it is possible to arrange the distance and orientation of T in a way next to O that the exciton transfer from O to T is faster than the internal conversion of the exciton from S₂ to S₁ within T or the energy transfer to the nano-units A, B when there is very high spectral overlap between the S₂ emission of O and the absorption of T and when the transition dipole moment orientations of O and T are nearly parallel.

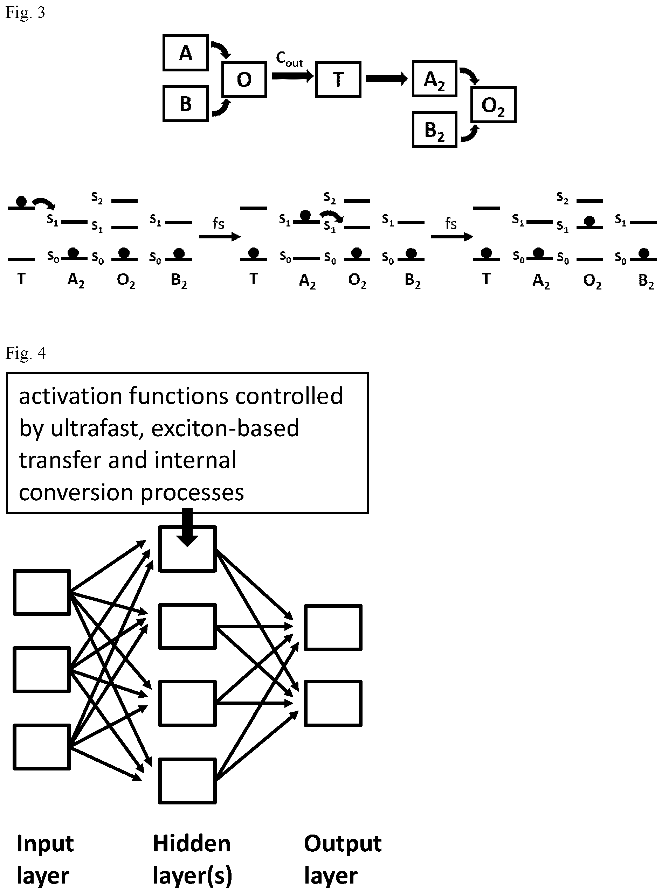

The exciton in the transfer nano-unit T can now be further transferred to a second identical half-adder A₂/B₂/O₂ for the next processing steps, for example, to form the input signal for the nano-unit A₂ of the second half adder A₂/B₂/O₂ (Fig. 3).

Alternatively, transfer nano-unit T can also transfer the excitonic signal back to an input Cᵢₙ of a full adder. Then, a bitwise full addition can be done in a cyclic way by feeding the inputs A and B by pulse sequences on the fs timescale. Such a cyclic processing scheme does actually not even need another nano-unit T if the Cₒᵤₜ excitation (S₂ of O) in Fig. 1 is back transferred to either nano-unit A or B with a time constant slower than reading out S, for example by S₁ transient absorption measurements of the nano-unit O, and faster than back-transfer to O feeding A and B with new signals.

In similar ways, full adders or any other logical circuits working on the nanoscale and fs-timescale can be realized and connected to entire logical networks processing information on the nanoscale and fs-timescale.

The array, resp. network logic, is not restricted to simple binary logic (i.e excited states are either populated or not) but it can also be used to work with different fractions of excitation state populations or probabilities of certain excitation states being populated. In the array, nano-units which are set up for all three possibilities of binary state population, excitation state populations, and excitation probabilities can be contained to construct complex networks of arrays. In such arrays, the three-dimensional distances, orientations, electronic state energies and spectral overlaps of the nano-units are arranged and selected such that the array is set up for transfer of excitons from the input position to the output position, preferably for pre-determined processing of signals from the input position to the output position. An application example is a neuronal network that is based on ultrafast signal transfer by exciton transfer on the nanoscale rather than microelectronic circuits (Fig. 4). A neuronal network comprises or consists of at least of one input layer, optionally at least one hidden layer, and at least one output layer, each of which layers consisting of networks of nodes called artificial neurons. In such a neuronal network based on nano-units, the nano-units form the nodes of the neuronal network and the nano-units at the input position form the input layer, an array between input and output position forms the at least one hidden layer, and the nano-units at the output position form the output layer. The so-called activation function of each artificial neuron can be controlled, or pre-determined, by ultrafast, exciton-based transfer and conversion processes by arranging individual nano-units at different distances and/or orientations. Training of such networks can be either by self-induced modifciations such as conformational changes or bleaching or by structuring the network to adapt the array based on existing knowledge of the activation function from conventional microelectronics.

The detector arranged at the output position is set up to detect energy levels of excitons of nano-units arranged at the output position of the array. Preferably, at positions of the array forming the output position, nano-units are located which are able to assume two different excitation states above electronic ground level, also known as excited-state absorption.

As an example, the detector can be formed by a photon-counting detector, e.g. a multi-pixel photon counter. The detector can also be a device set up for pump-probe detection of excited states of nano-units located at the output position. In general, the detector is set up to detect photons or excitons at the output positions.

In an embodiment, the nano-units have the ability to assume only one excited state, allowing the signal processor to form a half adder.

In an embodiment, at least the nano-units located at the output position, preferably nano-units of all positions of the array, have the ability to assume two different excited states, allowing the signal processor to form a full adder.

Positioning of nano-units on a carrier to produce the array of the signal processor can be done by known processes utilized for positioning or synthesizing e.g. nucleic acid molecules or peptides on positions of an array on a solid carrier. Alternatively, step-wise synthesis of a polymeric carrier with stepwise binding of excitable molecules can be used for producing the array of the signal processor. Further, arrays, especially 2-dimensional or 3-dimensional arrays representing networks can be produced by methods as known for synthesis of branched carbohydrates. Alternatively, nano-units can also be positioned by atomic force microscopes. Finally, the nanounits can also be arranged by selfassembly processes, other aggregtion mechanisms or using metal organic frameworks as a carrier.

In the array nano-units preferably have different possible excitation states, also termed electronic states, that have lifetimes on the order of at least the duration of the processing by energy transfer or internal processes, i.e. lifetimes at least larger than 1 fs, preferably larger than 1 ps, and more preferably larger than 1 ns. For use of the array in logic operations it is also advantageous if some nano-units have more than one electronic excitation state, such as O for example, allowing a nano-unit to store a signal, e.g. representing an information, such as, for example, S and C_{Out}, as depicted e.g. in Fig. 2 and Fig. 3. This is fulfilled if molecules that form nano-units contain conjugated aromatic or non-aromatic π-systems consisting of at least two conjugated double bonds or preferentially 5 or more conjugated double bonds or more preferably more than 10 double bonds. It is also fulfilled for nano-units formed by nanoparticles that have core diameter sizes in the range of 0.5-20 nm.

Dyes that fulfil the above requirements for forming nano-units are for example molecules with carotenoid or polyene structures, chlorophyll, coumarins, fluoresceins, azulene, perylenes, terrylenes, and in general polyaromatic compounds. Nanoparticles that fulfil the above requirements for nano-units are for example nanoparticles comprising or consisting of cores of Cadmium Sulfide (CdS), Cadmium Selenide (CdSe), or Cadmium Telluride (CdTe), or GaAs.

The nano-units are preferably selected to have electronic state energies and density of electronic states associated with these electronic states that allow for very fast energy transfer between these electronic states. According to the invention, and in agreement to Förster Theory or Dexter Theory, this is fulfilled, for example, when the emission spectrum of a nano-unit has a very high spectral overlap with the absorption spectrum of a neighboring nano-unit and if the transition dipole moments of both are high and of similar orientation. A high transition dipole moment is, for example, reflected in a high extinction coefficient. This can be either the extinction coefficient of a molecule's electronic ground state but also the extinction coefficient of the excited state absorption of excited states. A high transition dipole moment can also be reflected by a high fluorescence or photoluminescence quantum yield of a nano-unit. Optionally, so-called dark states that have small extinction coefficients can be part of or form a nano-unit. The timescale for energy transfer between these nano-units is preferentially on the order of at most 1 ps, and more preferentially of at most 100 fs and and more preferentially of at most 10 or 1 fs.

For the array suitable as a half adder (Fig. 1) with inputs A=1 and B=1 and outputs S=0 and Cₒᵤₜ=1 it is very advantageous, for example, when the S₁→S₀ emission spectrum of either the nano-unit A and B has a very high spectral overlap with the S₀→S₁ electronic ground state absorption and with the S₁→S₂ excited state absorption of O. It is further very advantageous when the transition dipole moments for the S₁-S₀ emission transition of the nano-units A and B are high and when the transition dipole moments for the S₀→S₁ electronic ground state absorption and for the S₁→S₂ excited state absorption of the nanounit O are high.

For further processing such as shown above with the subunit T (Fig. 2 and Fig. 3) it is very advantageous for the array, for example, when the S₂→S₀ emission spectrum of either the nanounit O has a very good spectral overlap with the S₀→S₁ absorption of the nano-unit T and when the S₁→S₀ emission spectrum of the nano-unit T has a very high spectral overlap with the S₀→S₁ absorption of the nano-unit A₂ and when all transitions have high transition dipole moments. This implies also that the electronic state energies of O, T and A₂ are slightly decreasing, thereby ensuring that the signal transferred via the excitons cannot be transferred back. For reasons of energy economics the stepwise decrease should, however, be as small as possible while simultaneously allowing for high spectral overlap between nano-units of the array, especially between the adjacenet nano-units.

For the logic process it is also very advantageous that in the array all nano-units that shall interact are at very close distances, preferentially at distances at or below the van der Waals contact distance i.e. below 1 nm or below 0.1 nm and that the angle between their transition dipole moment orientations is rather small, preferentially below 45°, more preferentially below 20°, more preferentially below 10°, below 5°, or below 1°.

In the signal processor, subunits can be present within the array, which subunits preferably operate separate from other nano-units, e.g. they preferably are either at large spacing and/or the angle between their transition dipole moment orientations should be rather close to 90°, each of spacing and angle of approx. 90° between the transition dipole moment orientations sufficient to avoid exiton transfer. For example, when the signal processor is set up for further processing, e.g. using a nano-unit T as shown in Fig. 3, from nano-unit O to A₂, this can be achieved when O is in direct contact with T, and T is in direct contact with A₂, but A₂ is in no direct contact with O but spaced from O. In addition, an angle of 45° between the transition dipole moments of O and T as well as an angle of 45° between the transition dipole moments of T and A₂ allows the signal based on transfer of excitons to proceed from O via T to A₂, but not from A₂ to O because they have transition dipole moment orientations at a 90° angle which does not allow for exciton transfer. Also, when all nano-units A, B and O have exactly parallel transition dipole moment orientations, there can be no transfer from the nano-unit A₂ to any nano-unit A,B or O because they then have all transition dipole moment orientations perpendicular to the transition dipole moment orientation of A₂. If all nano-units A₂, B₂ and O₂ have also parallel transition dipole moment orientations this ensures that that nano-units A₂, B₂ and O₂ can absorb excitons and emit excitons independently from nano-units A,B and O, since the latter have transition dipole moment orientations in perpendicular.

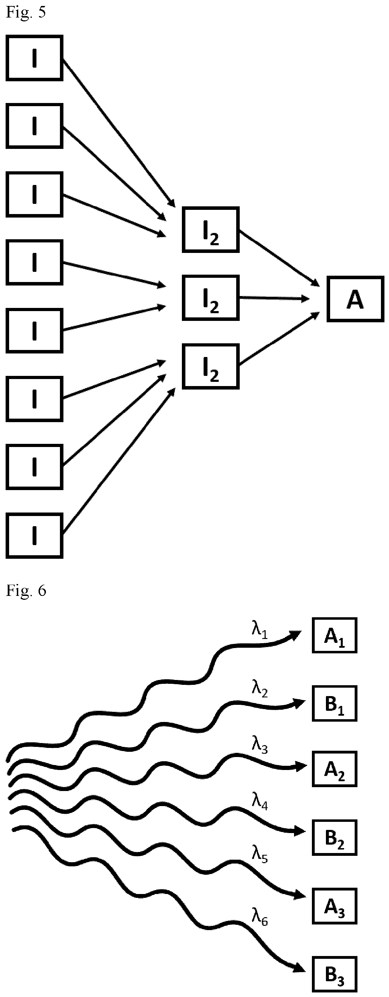

The first nano-units in an array to be energized, i.e. a nano-unit located at an input position, can be excited by nano-LEDs or electronically as an input device, for example. For example, A and B in Figs. 1-3 could be directly located next to a nano-electrode or a nanoLED of similar dimension as position A and B for excitation. Alternatively, light could be guided to the input positions via optical fibers as input device. These fibers may even have output diameters below the wavelength of the used light and would then act as nearfield fiber outputs that feed the inputs of the array. In a neuronal network based on an array of excitonic nano-units (Fig. 4) the nano-units can represent neuronal network nodes. Thus, in a neuronal network based on an array of excitonic nano-units (Fig. 4), for example, the inputs as well as the outputs are far fewer in number than the number of adjacent nano-units, which can form nodes, in between. Therefore, the input positions can also be separated by a larger spacing than the spacing of the remaining nano-units and thus the size requirements for the input positions is not so small as the size requirement of a nano-unit itself. Several input nano-units I, I₂ (Fig. 5), acting as input postions, i.e. as nano-units collecting energy from the input device, could also feed one input nano-unit A having a nanoscale size when surfaces of I are illuminated by radiation having a diameter at the sub µm scale. This could be done, for example, by excitation of the nano-units I with light and several nano-units set up for subsequent exciton transfer steps I→I₂→A.

Alternatively, different inputs could also be energized by an input device emanating different input excitation wavelengths. For this, different inputs nano-units A₁, A₂, A₃... and B₁, B₂, B₃.... can be located together in one input position on the sub µm scale. In case, the nano-units located in one input position have different absorption wavelengths, only distinct inputs are engergized by light of different wavelengths λ₁, λ₂, λ₃.... when the sub µm input position containing the different inputs nano-units A₁, A₂, A₃... and B₁, B₂, B₃.... is irradiated by the different wavelengths λ₁, λ₂, λ₃ at the same time (Fig. 6) or also after each other.

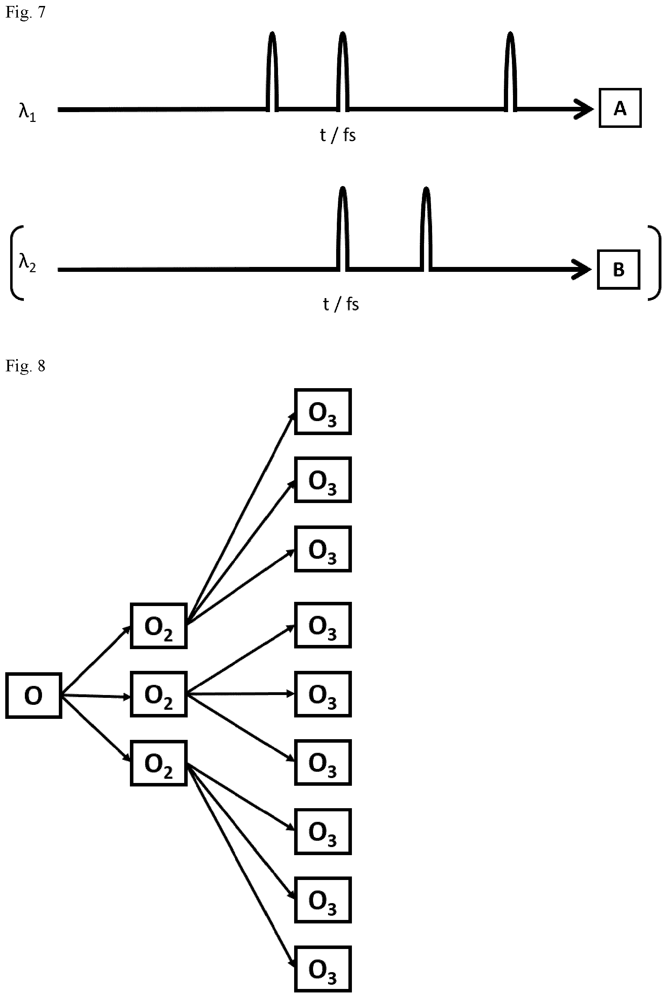

Different input energies can also be encoded as or embodied by pulse sequences of the energy applied to the input position on the ps or fs time scale for more than two inputs A or B (Fig. 7). Such temporally separated input pulse sequences generated by the input device are also suitable to feed cyclic excitonic nano-unit circuits in an array as described above. Such pulsed inputs on the fs time scale can be generated, for example, by fs-lasersystems and with mirror arrays that focus the output of such a laser with different time delays on the fs-timescale onto the input position. Different input "bits" could be altered by simply blocking the pulse paths of different time delays. This could be done mechanically or using, for example, optoacoustic reflecting elements.

Different inputs could also be encoded by different polarisations of the input light. The output electronic excitons or photons emanating out of one or more nano-units O can be read out by nano-electrodes, nano detector diodes or optical nearfield fibers arranged next to the output positions O. Alternatively, output photons of one or more nano-units O can be read out by magnifying the spatial emission pattern of several nano-units by a system of one or more optical lenses that focus the pattern onto nano detector diode arrays or optical fiber arrays or any other optical detector. Also the output could be distributed from on nano-unit O on the nm scale to a larger area on the sub µm- scale by a network of nano-units directing the electronic excitons via O→O₂→O₃ energy transfer to larger areas that are connected to a larger scale optical or electronic detector input (Fig. 8)

Alternatively, several outputs could also be encoded by different output emission wavelengths λ₁, λ₂, λ₃... of different output nano-units O,O₂, O₃ ..... (Fig. 9), or by pulsed outputs on the fs time scale (Fig. 10). Pulsed outputs would be generated, for example, by an array comprising a cyclic excitonic nanounit circuit as described above but also by other array structures when they are feed by input fs-pulses. Such pulsed outputs on the fs time scale can be read out using, for example, fs-upconversion techniques of fs-pump-probe laser systems.

Different outputs could also be encoded by different polarisations of the output light.

Fig. 11 shows an arrangement of an input device 1 formed by nanoLEDs, input lasers or near field fiber ends set up for emitting light at different times, different wavelengths, polarisations or at different positions, or nano electrodes, which input device 1 is directed onto nano-units 3 located at input positions 4 of an array 2. Array 2 comprises an arrangement of nano-units 3, herein represented by aromatic molecules or nanoparticles of different or the same electronic state structures, which nano-units 3 are arranged adjacent to one another, allowing for transfer 5 of excitons between adjacent nano-units 3. The electronic state structures and different distances and orientations enable the adjustment of logic operations such as shown in Figures 1-10 and particular the adjustment of the orientations allows varying the exciton flow strength useful in, and forming, neuronal networks. With a spacing from the input position 4, the array 2 has nano-units 3 located in output positions 6. The output positions are monitored by a detector 7, which is set up to receive excitons emitted by nano-units 3 located in output positions 6, or is set up to detect, e.g. by pump-probe spectroscopy, the excitation state of nano-units 3 located in output positions 6, or is set-up to detect the output excitons electronically. The nano-units 3 may be positioned directly to one another by aggregation, by directed positioning and/or can be bound, e.g. covalently, to a carrier 8. The general direction, indicated by arrow 8, of excitons is from the nano-units 3 located at the input positions 4 by transfer 5 of excitons between adjacent nano-units 3 across the array 2 to the nano-units 3 located at output positions 6, with detection of the excitation state and/or emission of excitons by detectors and/or transient absorption spectroscopy (7). For a neuronal network, the array of nano-units 3 which are schematically are depicted as one vertical column can each form one hidden layer, the output positions 6 can form an output layer, and the input positions 4 can form an input layer.

Fig.12 shows an array of the invention in the form of a simple arrangement (2) consisting of chlorophyll a (Chl a) molecules as input nanounits A (4) and Zeaxanthin (Zea) molecules as output nanounits O (6) for a half adder logic. Individual Zea output nanounits O can be embedded in several surrounding input Chl a nanounits by simple doping a solid state aggregate consisting of Chl a molecules with few Zea molecules, thereby guaranteeing very short distances between nanounit A and O for very fast exciton transfer. Ultrafast input laser pulses (1) of wavelengths corresponding to the Chl a S₀ → S₁ absorption of the input Chl a nanounits (~ 680 nm or smaller) can excite the input A. After that, subsequent exciton transfer occurs (5, 8), exciting the first excited state S₁ of the Zea. If there is no further input, the output can be read out by transient absorption spectroscopy (7) of the Zea output nanounits O strong Zea S₁ → Sₙ excited state absorption representing an signal (S) output =1 (compare also to Fig. 1). The strong Zea S₁ → Sₙ excited state absorption at ~ 550 nm can only be detected if the first excited state, S₁, of Zea (O) is populated. To improve the signal-to-noise ratio, several Zea output nanounits O can be detected simulatenously. The input and output nano-units (4, 6) are also the operating nano-units (3) in case of a simple two-nano-unit arrangement. A logic two bit addition logic operation can be reflected by two consecutive fs input laser pulses exciting the input Chl a nano-units. Again, the first pulse results in exciton transfer to the first excited state S₁ of the Zea. However, the second pulse results in exciton transfer to the second excited state S₂ of the Zea. Now, no Zea S₁ → Sₙ excited state absorption can be detected, corresponding to a zero output of a half or full-adder, signal(S) output =0. The multitude of Chl a input nanounits A surrounding a single Zea output nanounit O helps adjusting the laser pulse intensity in a way such that the Zea output nanounit is excited and re-excited to about 100 % with each pulse. The second excited state S₂ of the Zea output nano-unit now corresponds to the Carry (C_{Out}) signal=1. After a certain time, Carry (C_{Out}) signal=1 is converted back into signal(S) output =1 by Zea S₂ → S₁ internal conversion. This allows for a cyclic operation as described above. Further signal inputs lead to further logic operations as described above (Fig. 1).

Figure 13 shows the time dependence of various excited electronic states of the Chl a and Zea nano-units (3, 4, 6) of the example shown in Fig. 12. The time depencence is shown for the example of a logic operation with both inputs A=1 and B=1 resulting in the ouputs S=0 and C_{Out}=1. The inputs (1) are two fs-pulses with a time separation of 100 fs (the two inputs arrive at the sample at t=100 fs and t=200 fs, respectively). The first pulse at 100 fs excites Chl a into its Chl a S₁. Subsequently, a major fraction of the electronic excitation is transferred to Zea S₁ and the signal S becomes populated. The second pulse at t=200 fs either excites Chl a S₁ again with subsequent electronic excitation transfer Chl a S₁ + Zea S₁ → Chl a S₀ + Zea S₂ or as dominated here directly populates Zea S₁-> Sₙ. In both cases the population of Zea S₁ and other states belonging to Zea S₁ (Zea S₁ + Zea S* + Zea Sₕₒt=S) dissapear (signal output S=0) and the Carry output is intermediately stored in Zea sates belonging to Zea S₂ (Zea S₂+ Zea Sₙ, C_{Out}=1). The signal output S can be read out (7) by measuring the strong Zea S₁→ Sₙ excited state absorption shortly after t=200 fs (eg. at t=210 fs). When both pulses are applied (A=1, B=1), this signal is much lower as if only one (A=1,B=0 or A=0,B=1) or no pulse (A=0, B=0) would have been applied. After a certain time - again on the ultrafast timescale - the excitation states representing C_{Out}=1 are either back in the Zea S₁ state for the next processing round or could be transferred to a neighboring transfer nanounit T (not shown here, see e.g. Fig. 2).

## Claims

1. Signal processor having an array of nano-units, the array having at least one nano-unit located at an input position and at least one nano-unit located at an output position, wherein in the array nano-units which have an electronic ground state and at least one posssible electronic excitation state are arranged adjacently at a spacing set up for transfer of excitons from the input position to the output position, an input device arranged to energize the at least one nano-unit located at least one input position, a detector set up to detect excitons emanating at the output position of the array and/or a detector set up to detect the state of excitation of nano-units located at the output position.

2. Signal processor according to claim 1, wherein the input position, the array arranged between the input position and the output position, and the output position, each formed by nano-units, form a neuronal network.

3. Signal processor according to one of the preceding claims, wherein the nano-units are linked adjacently to one another.

4. Signal processor according to one of the preceding claims, wherein the nano-units are positioned directly adjacent to one another.

5. Signal processor according to one of the preceding claims, wherein the nano-units are covalently bound to a carrier.

6. Signal processor according to one of the preceding claims, wherein the nano-units have a relative orientation to one another to influence the transfer of excitons between nano-units, preferably the transition dipole moments of the nano-units have a relative orientation to one another to influence the transfer of excitons between nano-units.

7. Signal processor according to one of the preceding claims, wherein at least one of the nano-units has at least two possible electronic excitation states above its electronic ground state.

8. Signal processor according to one of the preceding claims, wherein the nano-units located at the output position have at least two possible electronic excitation states above their electronic ground state.

9. Signal processor according to one of the preceding claims, wherein the nano-units are selected from excitable nanoparticles, quantum dots, aromatic molecules, and a combination of at least two of these.

10. Signal processor according to one of the preceding claims, wherein the input device is set up to emit irradiation in a pulse sequence, of different wavelengths, and/or different polarisation, each modulated in dependence on an input string.

11. Signal processor according to one of the preceding claims, wherein the input device is set up to energize nano-units located in at least 10 input positions.

12. Signal processor according to one of the preceding claims, wherein the input device is a laser device set up to emit fs irradiation pulses.

13. Signal processor according to one of the preceding claims, wherein the detector is set up for measuring the excitation state of nano-units located at the output position by pump-probe spectroscopy.

14. Signal processor according to one of the preceding claims, wherein the detector is set up for measuring emission of nano-units located at the output position.

15. Signal processor according to one of the preceding claims, wherein the detector is set up for measuring the electronic state of nano-units located at the output position.

16. Signal processor according to one of the preceding claims, wherein the array is devoid of electrically conductive lines.

17. Process for processing data using a signal processor according to one of the preceding claims, comprising energizing nano-units located in at least one input position of an array of nano-units by emission from an input device and/or electronically from an input device, wherein the input device modulates the emission or electronic energizing in dependence on an input string of the data, transferring excitons across nano-units of the array from the input position to the output position, and detecting the excitation state of and/or emission by nano-units located at the output position.
